# FASCICULE DE BREVET EUROPEEN

(11) **EP 2 983 849 B1**
(45) Date de publication et mention de la délivrance du brevet: **07.06.2017**
(21) Numéro de dépôt: 14721465.4
(22) Date de dépôt: 09.04.2014
(51) Int. Cl.: B22D 27/04, B22C 9/04, C30B 11/00

(54) **MOULE DE FONDERIE MONOCRISTALLINE**
MONOKRISTALLINE SCHMELZFORM
MONOCRYSTALLINE SMELTING MOULD

(30) Priorité: 10.04.2013 FR 1353223
(43) Date de publication de la demande: 17.02.2016
(73) Titulaire: SNECMA, 75015 Paris (FR)
(72) Inventeur: DILLENSEGER, Serge, F-77550 Moissy-Cramayel Cedex (FR); COYEZ, Dominique, F-77550 Moissy-Cramayel Cedex (FR); FARGEAS, Serge, F-77550 Moissy-Cramayel Cedex (FR); GRAS, Hervé, F-77550 Moissy-Cramayel Cedex (FR); GUERCHE, Didier, F-77550 Moissy-Cramayel Cedex (FR)
(74) Mandataire: Calvo de Nó, Rodrigo
(86) Numéro de dépôt international: PCT/FR2014/050845
(87) Numéro de publication internationale: WO 2014/167243

(56) Documents cités:
- FR-A1- 2 734 187
- US-A- 4 548 255
- US-A- 4 940 073

## Description

### Arrière-plan de l'invention

La présente invention concerne le domaine de la fonderie, et plus particulièrement un moule pour fonderie, ainsi que des procédés de fabrication de moules carapaces et de fonderie utilisant un tel modèle.

Dans la description qui suit, les termes « haut », « bas », « horizontal » et « vertical » sont définis par l'orientation normale d'un tel moule lors de la coulée de métal dans son intérieur.

Des procédés de fonderie dits à cire perdue ou à modèle perdu sont connus depuis l'antiquité. Ils sont particulièrement adaptés pour la production de pièces métalliques avec des formes complexes. Ainsi, la fonderie à modèle perdu est notamment utilisée pour la production de pales de turbomachines.

Dans la fonderie à modèle perdu, la première étape est normalement la réalisation d'un modèle en matériau à température de fusion comparativement peu élevée, comme par exemple une cire ou résine. Ce modèle est lui-même enrobé de matériau réfractaire pour former un moule, et notamment un moule de type moule-carapace. Après évacuation ou élimination du matériau du modèle de l'intérieur du moule, ce qui donne son nom à ces procédés dits à modèle perdu, un métal en fusion est coulé dans ce moule, afin de remplir la cavité formée par le modèle dans le moule après son évacuation ou élimination. Une fois que le métal se refroidit et solidifie, le moule peut être ouvert ou détruit afin de récupérer une pièce métallique conforme à la forme du modèle. On entend par « métal », dans le présent contexte, tant des métaux purs que, surtout, des alliages métalliques.

Afin de pouvoir produire plusieurs pièces simultanément, il est possible de réunir plusieurs modèles dans une seule grappe dans laquelle ils sont reliés par un arbre formant, dans le moule, des canaux de coulée pour le métal en fusion.

Parmi les différents types de moules pouvant être utilisés dans la fonderie à modèle perdu, on connaît notamment les moules dits moules carapace, formés par trempage du modèle ou de la grappe de modèles dans une barbotine, suivi d'un saupoudrage du modèle ou de la grappe enduits de barbotine avec du sable réfractaire pour former une carapace autour du modèle ou de la grappe, et de la cuisson de cette carapace pour la fritter de manière à consolider l'ensemble. Plusieurs trempages et saupoudrages successifs peuvent être envisagés afin d'obtenir une carapace d'une épaisseur suffisante avant sa cuisson. On entend par « sable réfractaire », dans le présent contexte, tout matériau granulaire avec une granulométrie suffisamment fine pour satisfaire aux tolérances de production souhaitées, capable de résister, à l'état solide, aux températures du métal en fusion, et pouvant être consolidé d'un seul tenant lors de la cuisson de la carapace.

Afin d'obtenir des propriétés thermomécaniques particulièrement avantageuses dans une pièce produite par fonderie, il peut être souhaitable d'assurer une solidification dirigée du métal dans le moule. On entend par « solidification dirigée », dans le présent contexte, comme la maîtrise de la germination et croissance de cristaux solides dans le métal en fusion lors de son passage de l'état liquide à l'état solide. L'objet d'une telle solidification dirigée est celui d'éviter les effets négatifs des joints de grains dans la pièce. Ainsi, la solidification dirigée peut être colonnaire ou monocristalline. La solidification dirigée colonnaire consiste à orienter tous les joints de grains dans une même direction, de manière à ce qu'ils ne puissent pas contribuer à la propagation de fissures. La solidification dirigée monocristalline consiste à assurer la solidification de la pièce en un seul cristal, de manière à supprimer totalement les joints de grains.

Pour obtenir cette solidification dirigée monocristalline, le moule présente typiquement, sous la cavité de moulage, une cavité dite de démarrage reliée à la cavité de moulage par un canal sélecteur, comme divulgué par exemple dans le brevet français FR 2 734 189 et le brevet US 4,548,255. Lors de la solidification du métal dans le moule, on opère un refroidissement progressif de celui-ci à partir de la cavité de démarrage, de manière à provoquer la germination des cristaux dans celle-ci. Le rôle du canal sélecteur est, d'une part, de privilégier un grain unique, et d'autre part, de permettre la progression de ce grain unique vers la cavité de moulage à partir du front de cristallisation de ce grain germé dans la cavité de démarrage.

Un inconvénient de cette configuration est toutefois celui d'assurer la tenue mécanique du moule, en particulier quand celui-ci est du type dit « moule carapace », formé par des parois relativement fines autour des cavités et canaux destinés à recevoir le métal fondu, puisque la cavité de moulage sera en position haute au-dessus d'une cavité de démarrage normalement plus petite. Pour cela, il est habituel, comme illustré dans le brevet US 4,940,073, d'intégrer des tiges de soutien dans le moule.

Toutefois, ces tiges de soutien, qui pénètrent dans les cavités de démarrage et de moulage, peuvent interférer avec la germination et la propagation des grains.

### Objet et résumé de l'invention

L'invention vise donc à remédier à ces inconvénients en proposant un moule pour cavité monocristalline avec une cavité de moulage, une tige de soutien, une cavité de démarrage dont la forme permette d'assurer la germination de grains et un support adéquat à la tige de soutien, et un canal sélecteur relié au sommet de la cavité de démarrage pour la propagation d'un seul de ces grains vers la cavité de moulage.

Dans au moins un mode de réalisation, ce but est atteint grâce au fait que la cavité de démarrage comprend au moins un premier volume en forme d'entonnoir inversé, et un deuxième volume distinct en forme de socle, à la base du premier volume et sensiblement en saillie par rapport audit premier volume dans au moins une direction horizontale, et en ce que la tige de soutien est latéralement décalée par rapport au canal sélecteur et relie le deuxième volume de la cavité de démarrage à la cavité de moulage. Par « forme d'entonnoir inversé » on entend une forme à profil convergent telle que la section transversale la plus grande du premier volume est disposée adjacent au deuxième volume et la section transversale la plus petite du premier volume est disposée à l'opposé du deuxième volume. Cette forme n'est pas nécessairement conique ou même axisymétrique. Par « sensiblement en saillie » on entend que l'écart horizontal entre le bord inférieur du premier volume et le bord supérieur du deuxième volume est facilement détectable par des moyens de mesure conventionnels. Cette saillie horizontale du deuxième volume permet ainsi d'offrir un appui stable à la tige de soutien malgré son décalage latéral, qui permet d'éviter d'interférer avec la sélection de grains dans la transition entre la cavité de démarrage et le canal sélecteur à travers le premier volume en forme d'entonnoir.

En particulier, le deuxième volume peut être horizontalement en saillie autour du périmètre entier dudit premier volume, créant ainsi une discontinuité entre les premier et deuxième volumes qui contribue à la sélection de grains.

En outre, ledit premier volume peut être axisymétrique autour d'un axe vertical, facilitant ainsi la transition vers un canal sélecteur à section ronde, diminuant ainsi le risque de germination de grains parasites, tout comme celui de points faibles dans les parois du moule.

D'autre part, ledit deuxième volume peut être non-axisymétrique autour d'un axe vertical, notamment afin de faciliter le positionnement du modèle fusible de la cavité de démarrage lors de l'assemblage d'une grappe de modèles pour la fabrication du moule. Toutefois, le deuxième volume peut notamment être symétrique par rapport à un plan vertical, ce qui facilite la production par injection du modèle fusible qui servira à former cette cavité, en facilitant son démoulage.

Afin d'obtenir des conditions thermiques particulièrement homogènes au niveau dudit premier volume et du canal sélecteur, le décalage latéral de la tige de soutien par rapport au canal sélecteur peut être tel qu'une distance minimale entre la tige de soutien et le premier volume soit supérieure à la somme d'une épaisseur du moule autour de la tige de soutien et une épaisseur du moule autour du premier volume. Le moule peut notamment être un moule du type dit moule carapace, produit par le procédé dit à cire perdue ou à modèle perdu, ce qui permet d'obtenir un moule à parois relativement minces.

En particulier, ledit canal sélecteur peut être un canal sélecteur en chicane, afin notamment d'assurer une sélection fiable d'un seul grain de cristallisation. En outre, ledit canal sélecteur peut présenter une section transversale ronde, en particulier pour assurer l'intégrité des parois du moule autour de ce canal sélecteur, ainsi que pour éviter la germination de grains parasites dans des arêtes vives du canal sélecteur.

L'invention concerne également un procédé de fonderie comprenant au moins la fabrication d'un tel moule, par exemple par le procédé dit à cire perdue ou à modèle perdu, la coulée de métal en fusion dans le moule, le refroidissement et la solidification dirigée du métal à partir de la cavité de démarrage, et le décochage du moule pour récupérer une pièce métallique brute. Ce procédé peut ensuite comporter aussi, par exemple, une étape supplémentaire de finition de la pièce métallique brute.

### Brève description des dessins

L'invention sera bien comprise et ses avantages apparaîtront mieux, à la lecture de la description détaillée qui suit, d'un mode de réalisation représenté à titre d'exemple non limitatif. La description se réfère aux dessins annexés sur lesquels :
- la figure 1 illustre schématiquement la mise en oeuvre d'un procédé de fonderie à solidification dirigée ;
- la figure 2 illustre schématiquement une grappe de modèles de fonderie ;
- la figure 3 est une vue latérale de la cavité de démarrage suivant un mode de réalisation d'invention, avec le canal sélecteur correspondant, ainsi qu'une partie de la cavité de moulage correspondante, et une tige céramique de support ;
- la figure 4 est une vue du haut d'un modèle fusible de la cavité de démarrage de la figure 3.

### Description détaillée de l'invention

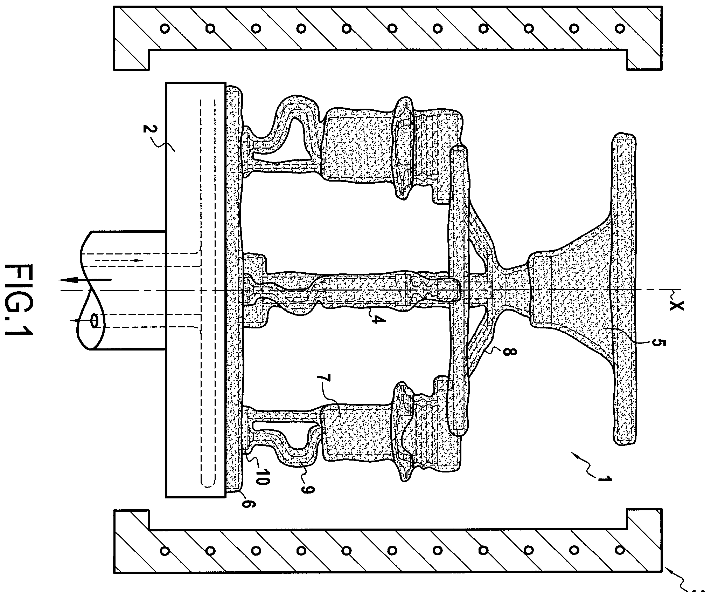

La figure 1 illustre comment un refroidissement progressif du métal en fusion destiné à obtenir une solidification dirigée peut typiquement être réalisé dans un procédé de fonderie.

Le moule carapace 1 utilisé dans ce procédé comporte un descendant central 4 s'étendant, en direction de l'axe principal X, entre un godet de coulée 5 et une base 6 en forme de plateau. Pendant l'extraction du moule carapace 1 de la chambre de chauffage 3, cette base 6 va être directement en contact avec une sole 2. Le moule carapace 1 comprend aussi une pluralité de cavités de moulage 7 arrangées en grappe autour du descendant central 4. Chaque cavité de moulage 7 est reliée au godet de coulée 5 par un canal d'amenée 8 au travers duquel le métal en fusion est introduit lors de sa coulée. Chaque cavité de moulage 7 est aussi également reliée par le bas, à travers un canal sélecteur 9 en chicane, à une plus petite cavité de démarrage 10 adjacente à la base 6.

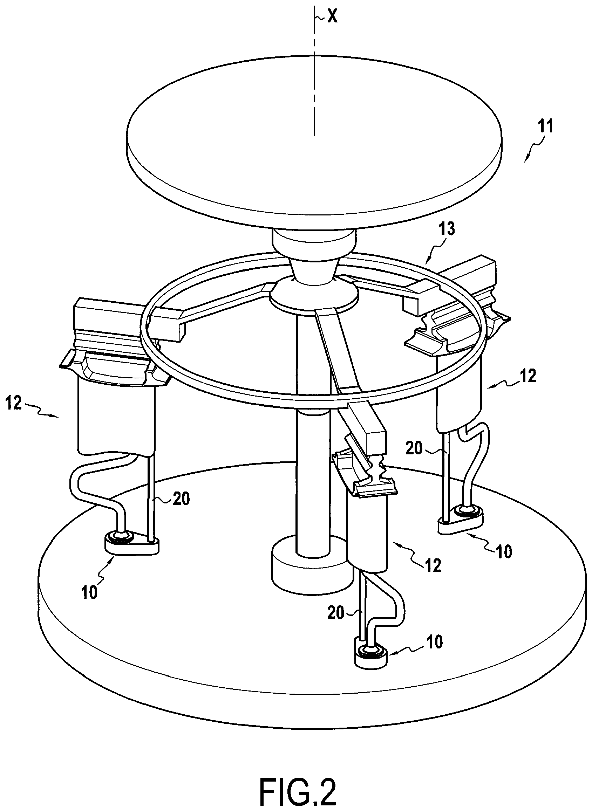

Le moule carapace 1 peut être produit par le procédé dit à cire perdue ou à modèle perdu. Une première étape d'un tel procédé est la création d'une grappe non permanente 11 comprenant une pluralité de modèles 12 reliés par un arbre 13, comme celle illustrée sur la figure 2. Les modèles 12 ainsi que l'arbre 13, sont destinés à former des volumes creux dans le moule carapace 1. Ils sont obtenus à partir d'une matière à basse température de fusion, comme une cire ou résine appropriées. Lorsque la production de grands nombres de pièces est envisagée, il est notamment possible de produire ces éléments par injection de la cire ou résine dans un moule permanent. Afin de soutenir chaque modèle 12, une tige de soutien 20 en matériau réfractaire, par exemple céramique, relie chacun des modèles 12 à la base de la grappe 11.

Dans ce mode de réalisation, pour produire le moule carapace 1 à partir de cette grappe non permanente 11, on procède à tremper la grappe 11 dans une barbotine, pour ensuite la saupoudrer avec un sable réfractaire. Ces étapes de trempage et saupoudrage peuvent être répétées plusieurs fois, jusqu'à former une carapace de sable imprégné de barbotine d'une épaisseur souhaitée autour de la grappe 11.

La grappe 11 enrobée de cette carapace peut ensuite être chauffée pour faire fondre et évacuer de l'intérieur de la carapace la matière à basse température de fusion de la grappe 11. Ensuite, dans une étape de cuisson à plus haute température, la carapace est frittée de manière à consolider le sable réfractaire pour former le moule carapace 1.

Le métal ou alliage métallique utilisé dans ce procédé de fonderie est coulé en fusion dans le moule carapace 1, à travers le godet de coulée 5, et remplit les cavités de moulage 7 à travers les canaux d'amenée 8. Pendant cette coulée, le moule carapace 1 est maintenu dans une chambre de chauffage 3, comme illustré sur la figure 1. Ensuite, afin d'obtenir le refroidissement progressif du métal en fusion, ce moule carapace 1, soutenu par un support 2 refroidi et mobile, est extrait de la chambre de chauffage 3, suivant un axe principal X, vers le bas. Le moule carapace 1 étant refroidi à travers sa base 6 par le support 2, la solidification du métal en fusion va se déclencher dans les démarrages 10 et se propager vers le haut suite à l'extraction progressive du moule carapace 1 de la chambre de chauffage 3 par le bas, suivant la flèche de la figure 1. L'étranglement formé par chaque sélecteur 9, ainsi que sa forme en chicane, vont toutefois assurer qu'un seul grain, parmi ceux ayant initialement germé dans chaque cavité de démarrage 10, va pouvoir continuer à s'étendre vers la cavité de moulage 7 correspondante.

Parmi les alliages métalliques pouvant être utilisés dans ce procédé, on compte notamment les alliages monocristallins de nickel, tels que, notamment, les AM1 et AM3 de SNECMA, mais aussi d'autres comme les CMSX-2®, CMSX-4®, CMSX-6 ®, et CMSX-10 ® du C-M Group, les René® N5 et N6 de General Electric, les RR2000 et SRR99 de Rolls-Royce, et les PWA 1480, 1484 et 1487 de Pratt & Whitney, entre autres. Le tableau 1 illustre les compositions de ces alliages :

**Tableau 1 : Compositions d'alliages de nickel monocristallins en % massique**

| Alliage | Cr | Co | Mo | W | Al | Ti | Ta | Nb | Re | Hf | C | B | Ni |
|---|---|---|---|---|---|---|---|---|---|---|---|---|---|
| CMSX-2 | 8,0 | 5,0 | 0,6 | 8,0 | 5,6 | 1,0 | 6,0 | - | - | - | - | - | Bal |
| CMSX-4 | 6,5 | 9,6 | 0,6 | 6,4 | 5,6 | 1,0 | 6,5 | - | 3,0 | 0,1 | - | - | Bal |
| CMSX-6 | 10,0 | 5,0 | 3,0 | - | 4,8 | 4,7 | 6,0 | - | - | 0,1 | - | - | Bal |
| CMSX-10 | 2,0 | 3,0 | 0,4 | 5,0 | 5,7 | 0,2 | 8,0 | - | 6,0 | 0,03 | - | - | Bal |
| René N5 | 7,0 | 8,0 | 2,0 | 5,0 | 6,2 | - | 7,0 | - | 3,0 | 0,2 | - | - | Bal |
| René N6 | 4,2 | 12,5 | 1,4 | 6,0 | 5,75 | - | 7,2 | - | 5,4 | 0,15 | 0,05 | 0,004 | Bal |
| RR2000 | 10,0 | 15,0 | 3,0 | - | 5,5 | 4,0 | - | - | - | - | - | - | Bal |
| SRR99 | 8,0 | 5,0 | - | 10,0 | 5,5 | 2,2 | 12,0 | - | - | - | - | - | Bal |
| PWA1480 | 10,0 | 5,0 | - | 4,0 | 5,0 | 1,5 | 12,0 | - | - | - | 0,07 | - | Bal |
| PWA1484 | 5,0 | 10,0 | 2,0 | 6,0 | 5,6 | - | 9,0 | - | 3,0 | 0,1 | - | - | Bal |
| PWA1487 | 5,0 | 10,0 | 1,9 | 5,9 | 5,6 | - | 8,4 | - | 3,0 | 0,25 | - | - | Bal |
| AM1 | 7,0 | 8,0 | 2,0 | 5,0 | 5,0 | 1,8 | 8,0 | 1,0 | - | - | - | - | Bal |
| AM3 | 8,0 | 5,5 | 2,25 | 5,0 | 6,0 | 2,0 | 3,5 | - | - | - | - | - | Bal |

Après le refroidissement et la solidification du métal dans le moule carapace 1, celui-ci pourra être décoché pour libérer les pièces métalliques, lesquelles pourront ensuite être finies par des procédés d'usinage et/ou des traitements de surface.

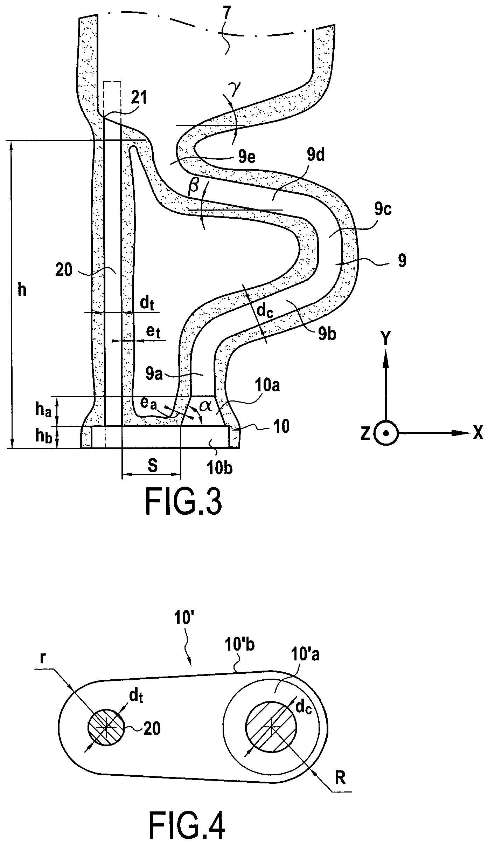

La figure 3 illustre plus spécifiquement la forme de l'une des cavités de démarrage 10, avec le canal sélecteur 9 correspondant, ainsi qu'une partie de la cavité de moulage 7 reliée à la cavité de démarrage 10 par ce canal sélecteur 9. On peut ainsi voir comment la cavité de démarrage 10 comprend un premier volume 10a de type à profil convergent vers le haut, c'est à dire en forme d'entonnoir inversé, et un deuxième volume 10b distinct, à la base du premier volume 10a. La convergence vers le haut du premier volume est telle que la section transversale la plus grande du premier volume est disposée adjacente au deuxième volume et la section transversale la plus petite du premier volume est disposée à l'opposé du deuxième volume. En d'autres termes, la plus grande section transversale du premier volume 10a est disposée en position inférieure par rapport à la plus petite section transversale selon l'orientation de la figure 3. Avantageusement, ce deuxième volume 10b présente une section transversale disposée horizontalement sensiblement constante, en saillie par rapport au premier volume 10a tout autour de ce premier volume 10a, mais de manière plus importante dans une direction principale. L'extrémité inférieure de la tige 20 est reçue dans cette saillie latérale du deuxième volume 10b.

Dans le mode de réalisation illustré, le deuxième volume 10b présente une hauteur h_{b} d'au moins 5 mm afin d'offrir un ancrage suffisant à la tige 20. Le bord supérieur de ce deuxième volume 10b est arrondi afin d'éviter des concentrations de contrainte et par conséquent des criques à cet endroit de la moule carapace 1. De telles criques pourraient en effet générer des fines fuites de métal contenues dans la paroi de la moule carapace 1 qui pourraient constituer des sites de germination de grains parasites. Le rayon de cet arrondi peut être, par exemple, d'environ 0,5 mm.

Les transitions entre le premier volume 10a et le deuxième volume 10b, ainsi qu'entre le premier volume 10a et le canal sélecteur 9 sont également arrondies pour les mêmes raisons. L'inclinaison a (ALPHA) par rapport à l'horizontale d'une ou des parois du premier volume 10a selon un plan supposé vertical peut être, par exemple, entre 40° et 70°. Cette inclinaison permet d'effectuer une première sélection des grains et d'éviter des retassures en fin de solidification qui seraient susceptibles de générer des sites de germination de grains parasites. Toutefois, d'autres inclinaisons peuvent être envisagées suivant la forme du premier volume 10a.

Bien que, dans le mode de réalisation illustré, ce premier volume 10a ait une forme tronconique, d'autres formes à section horizontale décroissante vers le haut, et en particulier mais pas uniquement des formes axisymétriques, seraient également envisageables. Par exemple, une forme hémisphérique à convexité tournée vers le haut est aussi envisageable. Indépendamment de sa forme, la hauteur hₐ du premier volume 10a peut être, par exemple, entre 2 et 20 mm.

Le canal sélecteur 9 est en forme de chicane avec cinq segments successifs 9a à 9e, à section transversale ronde sensiblement constante, avec un diamètre d_{c} d'au moins 5 mm, de préférence entre 6 et 8 mm, par exemple. Ce choix de diamètres permet d'effectuer la sélection du monograin, tout en évitant que, par un diamètre trop faible du canal sélecteur 9, des criques se forment dans les parois du moule carapace 1 ce qui pourrait favoriser la germination de grains parasites. Pour la même raison, les raccords entre les segments successifs 9a à 9e sont arrondis, par exemple avec un rayon d'environ 7 mm. Ces cinq segments successifs 9a à 9e comprennent des premier et cinquième segments 9a,9e sensiblement verticaux, un troisième segment 9c sensiblement vertical aussi, mais latéralement décalé par rapport aux premier et cinquième segments 9a,9e, et des deuxième et quatrième segments 9b,9d inclinés reliant les extrémités du troisième segment 9c à, respectivement, lesdits premier et cinquième segments 9a,9e. L'inclinaison β (BETA) desdits deuxième et quatrième segments 9b,9d par rapport à l'horizontale peut être entre 5° et 45°, par exemple. La hauteur globale h de l'ensemble de la cavité de démarrage 10 et du canal sélecteur 9 peut être, par exemple, entre 30 et 40 mm.

La partie inférieure de la cavité de moulage 7 est également visible sur la figure 3. Afin d'assurer la transition entre le canal sélecteur 9 et cette cavité de moulage 7, pour éviter la création de grains parasites à cet endroit critique du moule 1, les bords inférieurs de cette cavité de moulage 7 sont inclinés et arrondis. L'angle d'inclinaison Y (GAMMA) de ces bords par rapport à l'horizontale peut également être entre 5° et 45°, par exemple. Une courbe canonique relie ces bords arrondis au canal sélecteur 9. Cette courbe canonique est constituée d'arrondis avec des rayons proches de ceux des bords, afin d'éviter des accidents de forme contribuant à la germination de grains parasites.

La tige 20 pénètre dans la cavité de moulage 7 à travers l'un de ses bords inférieurs arrondis. Afin d'éviter la formation interstices susceptibles de constituer des sites de germination de grains métalliques parasites, le raccordement 21 de la tige 20 à la cavité de moulage 7 présente le plus petit rayon d'angle possible, ou aucun, et ceci tout autour de la tige 20. La tige de soutien 20 peut être réalisée en un matériau réfractaire tel que qu'une céramique, en particulier l'alumine et peut présenter une section transversale de diamètre dₜ de, par exemple, 3 mm.

La figure 4 illustre une vue du haut du modèle fusible 10' utilisé pour former la cavité de démarrage 10. Les formes des premier et deuxième volumes 10'a,10'b de ce modèle fusible 10' correspondront à celles des premier et deuxième volumes 10a, 10b de la cavité de démarrage 10. Comme on peut voir sur cette figure, le deuxième volume 10'b de ce modèle fusible 10' présente une section horizontale symétrique formée par deux arcs de cercle de rayons différents, dont les extrémités sont reliées par des lignes droites. Cette forme permet notamment de correctement orienter le modèle 10' lors de l'assemblage de la grappe 11. L'un desdits arcs de cercle, avec un rayon R, est centré sur l'axe central du premier volume 10'a du modèle fusible 10', tandis que l'autre arc de cercle, avec un rayon r sensiblement inférieur au rayon R, est centré sur l'axe central de la tige 20. La distance minimale S entre la tige 20 et le premier volume 10a de la cavité de démarrage 10 est supérieure à la somme des épaisseurs et et eₐ des parois du moule 1 autour de, respectivement, lesdits tige 20 et premier volume 10a, de manière à éviter un chevauchement de ces parois qui nuirait à l'homogénéité thermique au sein dudit premier volume 10a de la cavité de démarrage 10.

Quoique la présente invention ait été décrite en se référant à un exemple de réalisation spécifique, il est évident que des différentes modifications et changements peuvent être effectués sur ces exemples sans sortir de la portée générale de l'invention telle que définie par les revendications. En outre, des caractéristiques individuelles des différents modes de réalisation évoqués peuvent être combinées dans des modes de réalisation additionnels. Par conséquent, la description et les dessins doivent être considérés dans un sens illustratif plutôt que restrictif.

## Revendications

1. Moule (1) pour fonderie monocristalline comprenant au moins une cavité de moulage (7) ;
une cavité de démarrage (10) avec au moins :
un premier volume (10a) en forme d'entonnoir inversé ; et
un deuxième volume (10b) distinct en forme de socle à la base du premier volume et sensiblement en saillie par rapport audit premier volume dans au moins une direction horizontale ; et
un canal sélecteur (9) reliant ladite cavité de démarrage (10) à ladite cavité de moulage (7) ; et
**caractérisé en ce qu'**il comprend en outre une tige de soutien (20), latéralement décalée par rapport audit canal sélecteur, et reliant le deuxième volume (10b) de la cavité de démarrage (10) à la cavité de moulage (7).

2. Moule (1) suivant la revendication 1, dans lequel une extrémité inférieure de la tige de soutien (20) est reçue dans ladite saillie latérale du deuxième volume (10b).

3. Moule (1) suivant la revendication 2, dans lequel une distance minimale entre la tige de soutien (20) et le premier volume (10a) est supérieure à la somme d'une épaisseur du moule (1) autour de la tige de soutien (20) et une épaisseur du moule (1) autour du premier volume (10a).

4. Moule (1) suivant l'une quelconque des revendications précédentes, dans lequel le deuxième volume (10b) est horizontalement en saillie autour du périmètre entier dudit premier volume.

5. Moule (1) suivant l'une quelconque des revendications précédentes, dans lequel ledit premier volume (10a) est axisymétrique autour d'un axe vertical.

6. Moule (1) suivant l'une quelconque des revendications précédentes, dans lequel ledit deuxième volume (10b) est non-axisymétrique autour d'un axe vertical.

7. Moule (1) suivant l'une quelconque des revendications précédentes, dans lequel ledit canal sélecteur (9) est un canal sélecteur en chicane.

8. Moule (1) suivant l'une quelconque des précédentes, dans lequel ledit canal sélecteur (9) présente une section transversale ronde.

9. Procédé de fonderie comprenant au moins les étapes suivantes :
fabrication d'un moule (1) suivant l'une quelconque des revendications précédentes ;
coulée de métal en fusion dans le moule (1);
refroidissement et solidification dirigée du métal à partir de la cavité de démarrage (10) ; et
décochage du moule (1) pour récupérer une pièce métallique brute.

## Patentansprüche

1. Form (1) für monokristallines Gießen, die wenigstens umfasst einen Formhohlraum (7),
einen Starthohlraum (10) mit wenigstens:
einem ersten Raum (10a) mit der Form eines umgekehrten Trichters, und
einem separaten sockelförmigen zweiten Raum (1 0b) an der Basis des ersten Raums und gegenüber dem ersten Raum in wenigstens einer horizontalen Richtung im Wesentlichen vorspringend, und
einen Auswahlkanal (9), der den Starthohlraum (10) mit dem Formhohlraum (7) verbindet, und
**dadurch gekennzeichnet, dass** sie ferner eine Stützstange (20) umfasst, die gegenüber dem Auswahlkanal seitlich versetzt ist und die den zweiten Raum (10b) des Starthohlraums (10) mit dem Formhohlraum (7) verbindet.

2. Form (1) nach Anspruch 1, bei der ein unteres Ende der Stützstange (20) in dem seitlichen Vorsprung des zweiten Raums (10b) aufgenommen ist.

3. Form (1) nach Anspruch 2, bei der ein Mindestabstand zwischen der Stützstange (20) und dem ersten Raum (10a) größer ist als die Summe aus einer Dicke der Form (1) um die Stützstange (20) herum und einer Dicke der Form (1) um den ersten Raum (10a) herum.

4. Form (1) nach einem der vorhergehenden Ansprüche, bei der der zweite Raum (10b) um den vollständigen Umfang des ersten Raums herum horizontal vorspringend ist.

5. Form (1) nach einem der vorhergehenden Ansprüche, bei der der erste Raum (10a) um eine vertikale Achse herum achsensymmetrisch ist.

6. Form (1) nach einem der vorhergehenden Ansprüche, bei der der zweite Raum (10b) um eine vertikale Achse herum nicht achsensymmetrisch ist.

7. Form (1) nach einem der vorhergehenden Ansprüche, bei der der Auswahlkanal (9) ein zickzackförmiger Auswahlkanal ist.

8. Form (1) nach einem der vorhergehenden Ansprüche, bei der der Auswahlkanal (9) einen runden Querschnitt aufweist.

9. Gießverfahren, das wenigstens die folgenden Schritte umfasst:
Herstellen einer Form (1) nach einem der vorhergehenden Ansprüche,
Gießen von Metallschmelze in die Form (1),
Abkühlen und gerichtete Erstarrung des Metalls ausgehend von dem Starthohlraum (10) und
Ausleeren der Form (1), um ein Rohmetallteil zu gewinnen.

## Claims

1. A mold (1) for monocrystalline casting, the mold comprising at least:
a molding cavity (7);
a starter cavity (10) having at least:
a first volume (10a) in the form of an upside-down funnel; and
a distinct second volume (10b) forming a plinth at the bottom of the first volume and projecting perceptibly relative to said first volume in at least one horizontal direction; and
a selector channel (9) connecting said starter cavity (10) to said molding cavity (7); and
the mold being **characterized in that** it further comprises a support rod (20) that is laterally offset relative to said selector channel, and that connects the second volume (10b) of the starter cavity (10) to the molding cavity (7).

2. A mold (1) according to claim 1, wherein a bottom end of the support rod (20) is received in said lateral projection of the second volume (10b).

3. A mold (1) according to claim 2, wherein a minimum distance between the support rod (20) and the first volume (10a) is greater than the sum of a thickness of the mold (1) around the support rod (20) plus a thickness of the mold (1) around the first volume (10a).

4. A mold (1) according to any preceding claim, wherein the second volume (10b) projects horizontally around the entire perimeter of said first volume.

5. A mold (1) according to any preceding claim, wherein said first volume (10a) is axisymmetric about a vertical axis.

6. A mold (1) according to any preceding claim, wherein said second volume (10b) is not axisymmetric about a vertical axis.

7. A mold (1) according to any preceding claim, wherein said selector channel (9) is a baffle-shaped selector channel.

8. A mold (1) according to any preceding claim, wherein said selector channel (9) presents a round cross-section.

9. A casting method comprising at least the following steps:
fabricating a mold (1) according to any preceding claim;
casting molten metal into the mold (1);
cooling the metal with directional solidification of the metal starting from the starter cavity (10); and
knocking out the mold (1) in order to recover the raw metal casting.
